(19) Europäisches Patentamt
European Patent Office
Office européen des brevets

(11) **EP 4 498 590 A1**

(12) **EUROPEAN PATENT APPLICATION**
published in accordance with Art. 153(4) EPC

(43) Date of publication:
**29.01.2025 Bulletin 2025/05**

(21) Application number: **22933623.5**

(22) Date of filing: **21.11.2022**

(51) International Patent Classification (IPC):
$H02M\ 7/48^{(2007.01)}$    $H01L\ 25/07^{(2006.01)}$
$H01L\ 25/18^{(2023.01)}$    $H02M\ 1/08^{(2006.01)}$

(52) Cooperative Patent Classification (CPC):
**H01L 25/07; H01L 25/18; H02M 1/08; H02M 7/48**

(86) International application number:
**PCT/JP2022/042988**

(87) International publication number:
**WO 2023/181493 (28.09.2023 Gazette 2023/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **23.03.2022 JP 2022046529**

(71) Applicant: **Minebea Power Semiconductor Device Inc.**
**Hitachi-shi, Ibaraki, 319-1221 (JP)**

(72) Inventors:
• **MIMA, Akira**
  **Tokyo 100-8280 (JP)**
• **ARAI, Taiga**
  **Hitachi-shi, Ibaraki 319-1221 (JP)**
• **KONNO, Akitoyo**
  **Hitachi-shi, Ibaraki 319-1221 (JP)**
• **SAITO, Katsuaki**
  **Hitachi-shi, Ibaraki 319-1221 (JP)**

(74) Representative: **MERH-IP Matias Erny Reichl Hoffmann**
**Patentanwälte PartG mbB**
**Paul-Heyse-Straße 29**
**80336 München (DE)**

(54) **SEMICONDUCTOR DEVICE AND POWER CONVERSION DEVICE**

(57)    To provide a semiconductor device having an inverter circuit constituted of upper and lower arms, in which detection accuracy of a short-circuit current can be improved by increasing the inductance of a main current time change rate (di/dt) detection circuit without increasing the main circuit inductance. The semiconductor device includes: an upper arm switching element having a gate, a first main electrode, and a second main electrode serving as a gate reference potential; a positive electrode terminal serving as an external electrode electrically connected to the first main electrode and through which a main current flows; a first auxiliary terminal serving as an external electrode which is electrically connected to the second main electrode and capable of detecting a potential of the second main electrode, and through which the main current is made to be prevented from flowing; and a second auxiliary terminal serving as an external electrode which is electrically connected to an AC terminal and arranged close to the positive electrode terminal and through which a main current subjected to magnetic coupling is made to be prevented from flowing.

*FIG. 1B*

**Description**

Technical Field

The present invention relates to the structure of a semiconductor device, and particularly to a technique which is effective when applied to a power module which controls large currents used for motor drives of an electric vehicle and an electric railway, etc.

Background Art

Recently, an inverter device has been widely used in a variety of applications such as motor drives for an electric vehicle and an electric railway, an air conditioner and a refrigerator for household use, an industrial pump, an elevator, etc., and there has been a demand for even higher output density.

In order to increase the output density of the inverter device, it is effective to reduce the size and weight of the inverter device. There is a strong demand for miniaturization of a power module mounted in an inverter device.

An inverter device has the function of converting DC power supplied from a DC power supply into AC power for supplying to an AC electrical load such as a rotating electrical machine, or the function of converting AC power generated by a rotating electrical machine into DC power for supplying to a DC power supply. Therefore, the inverter device is also called a "power conversion device". Hereinafter, it will be referred to uniformly as a "power conversion device".

A power module used in a power conversion device is generally configured by bonding an insulating substrate formed with a wiring pattern on a heat dissipation base by soldering or the like, and mounting a power semiconductor element on the wiring pattern of the insulating substrate by soldering or the like. The power semiconductor element is provided with electrodes on the front and back sides. The back electrode is connected to a wiring pattern on an insulating substrate, and the front electrode is connected to a wiring pattern on an insulating substrate via wires or the like.

In a power module for higher power such as for an electric railway, a plurality of power semiconductor elements are mounted on an insulating substrate. Further, it is possible to handle large currents by mounting a plurality of the insulating substrates.

A MOSFET (Metal-Oxide-Semiconductor Field-Effect Transistor), an IGBT (Insulated Gate Bipolar Transistor), a freewheel diode, etc. are mounted, as switching elements, on the power semiconductor element mounted on the insulating substrate.

In a power conversion device, IGBTs and freewheel diodes serving as power semiconductor elements are connected in parallel, and further, the two of them are connected in series and then connected to a DC power supply. The IGBT and freewheel diode connected to the positive electrode side of the DC power supply are called an upper arm, and the IGBT and freewheel diode connected to the negative electrode side of the DC power supply are called a lower arm. Further, a terminal drawn out from a connection portion between the upper arm IGBT and the lower arm IGBT is referred to as an output terminal.

It is possible to take out AC power from the output terminal by alternately repeating ON/OFF of the IGBTs in the upper arm and the lower arm. By connecting a plurality of inverter circuits equipped with IGBTs and diodes in parallel to such upper and lower arms, it is possible to convert DC power to AC power or AC power to DC power with larger output power.

A power semiconductor element includes on the back surface, a drain electrode (in the case of a unipolar transistor), a collector electrode (in the case of a bipolar transistor), and a cathode electrode (in the case of a freewheel diode) as the back electrodes through which a main current flows, and includes on the front surface, a gate electrode through which a control current flows, and a source electrode (in the case of a unipolar transistor), an emitter electrode (in the case of a bipolar transistor), and an anode electrode (in the case of a freewheel diode) as the surface electrodes through which the main current flows.

Conventionally, the back electrode was joined to a circuit board by lead solder or lead-free solder. Further, an aluminum-based material is used for the surface electrode, and an aluminum-based wire or a copper-based lead as a wire is bonded onto the surface electrode.

For example, a power module used to drive the motor of an electric vehicle has a breakdown voltage of 600V or more and a current capacity of 300A or more. In the case of an electric railway, the breakdown voltage is 3.3 kV or more, and the current capacity is 1200 A or more. In order to handle these large currents, there is a need to pass a current of several hundred amperes per power semiconductor element chip. Therefore, it is usually necessary to ultrasonically bond a plurality of thick wirers with a diameter of about 300 um to 550 um onto the surface electrode and to join copper leads by solder or the like.

In recent years, solder has been replaced by sintered metals having excellent heat resistance and long life, and copper wires more excellent in heat resistance than aluminum, but the demand for improved current capacity of a power module is further increasing, and a current flowing per chip is increasing. Therefore, the amount of heat generated increases, and the junctions around the chip are exposed to greater temperature fluctuations, thereby increasing the risk of destruction. For this reason, it has become an important issue to detect abnormalities in the power module and deal therewith before the destruction.

As the background art in this technical field, there is known, for example, a technique such as that described in Patent Literature 1. Patent Literature 1 discloses means of detecting a voltage generated in a wiring inductance component connected to a terminal with a lower potential of a pair of main terminals mounted on a power module. In Patent Literature 1, when an IGBT element is abnormally short-circuited, a voltage generated in a detection inductance and a gate voltage are used to prevent false detection of an abnormal state such as an overcurrent.

Further, there has been disclosed in Patent Literature 2, a semiconductor device including a control unit which detects a potential difference between predetermined terminals in at least one emitter wiring of a plurality of arms constituting a power module on the basis of the values of a parasitic resistance component and a parasitic inductance component parasitic in the emitter wiring between the terminals, and which is configured to independently perform short-circuit detection and overcurrent detection of a switching element using the detected potential difference.

Citation List

Patent Literature

Patent Literature 1: Japanese Unexamined Patent Application Publication No. 2007-259533
Patent Literature 2: Japanese Unexamined Patent Application Publication No. 2017-92789

Summary of Invention

Technical Problem

By the way, due to the demand for miniaturization of the power module, a power module with a 2in1 configuration in which upper and lower arms are mounted in the same package are becoming mainstream. On the other hand, the drive circuit which controls the power conversion device has a configuration in which the upper and lower arms are independent from each other from the viewpoint of insulation. For example, when either of the upper and lower arms fails and a short-circuit current flows, and the gate of the other pair of arms turns ON, a short-circuit current flows between the upper and lower arms, and failure detection is possible based on the potential difference generated by the emitter wiring parasitic inductance provided in either of the upper and lower arms.

However, in the case of a load short-circuit instead of a short-circuit between the upper and lower arms, for example, as described in Patent Literature 1 described above, when detection is possible only in the lower arm by the emitter wiring inductance, protection is no longer possible the moment the upper arm turns ON.

Further, as described in Patent Literature 2 described above, when the upper and lower arms are each provided with a short-circuit detection circuit based on the emitter wiring inductance, the wiring connecting the upper arm and the lower arm is generally extremely short, and the value of the emitter wiring inductance of the upper arm tends to be smaller. There is a disadvantage that when the emitter wiring inductance of the upper arm becomes small, the potential difference generated during the abnormal short circuit is small, and sufficient detection sensitivity cannot be obtained.

There is also considered a method of extending the upper arm emitter wiring to increase the inductance which contributes to detection, but this method increases the main circuit inductance of the inverter device, and there is a trade-off relationship between the two.

Therefore, an object of the present invention is to provide a semiconductor device having an inverter circuit constituted of upper and lower arms, in which detection accuracy of a short-circuit current can be improved by increasing the inductance of a main current time change rate (di/dt) detection circuit without increasing the main circuit inductance, and a power conversion device using the same.

Solution to Problem

In order to solve the above problems, a semiconductor device of the present invention includes: an upper arm switching element having a gate, a first main electrode, and a second main electrode serving as a gate reference potential; a positive electrode terminal serving as an external electrode electrically connected to the first main electrode and through which a main current flows; a first auxiliary terminal serving as an external electrode which is electrically connected to the second main electrode and capable of detecting a potential of the second main electrode, and through which the main current is made to be prevented from flowing; and a second auxiliary terminal serving as an external electrode which is electrically connected to an AC terminal and arranged close to the positive electrode terminal and through which a main current subjected to magnetic coupling is made to be prevented from flowing.

Advantageous Effects of Invention

According to the present invention, it is possible to realize a semiconductor device having an inverter circuit constituted of upper and lower arms, in which detection accuracy of a short-circuit current can be improved by increasing the inductance of a main current time change rate (di/dt) detection circuit, without increasing the main circuit inductance, and a power conversion device using the semiconductor device.

Thus, it is possible to improve the reliability of the semiconductor device and the power conversion device using the same.

Objects, configurations, and effects other than the above will be apparent from the description of the following embodiments.

Brief Description of Drawings

FIG. 1A is an internal circuit configuration diagram of a conventional semiconductor device.

FIG. 1B is an internal circuit configuration diagram of a semiconductor device according to a first embodiment of the present invention.

FIG. 2A is a cross-sectional structural diagram of the conventional semiconductor device.

FIG. 2B is a cross-sectional structural diagram of the semiconductor device according to the first embodiment of the present invention.

FIG. 3 is a diagram conceptually showing the detection principle of a short-circuit current according to the present invention.

FIG. 4 is a top view of a semiconductor device according to a second embodiment of the present invention.

FIG. 5 is a cross-sectional structural diagram of a semiconductor device according to a third embodiment of the present invention.

FIG. 6 is a cross-sectional structural diagram of a semiconductor device according to a fourth embodiment of the present invention.

FIG. 7 is a perspective view of a power module according to a fifth embodiment of the present invention.

FIG. 8 is a perspective view of a power module according to a sixth embodiment of the present invention. Description of Embodiments

One embodiment of the invention will now be described with reference to the drawings. In the following, the same configurations are indicated by the same reference numerals in all the drawings, and the overlapped description thereof is omitted.

First Embodiment

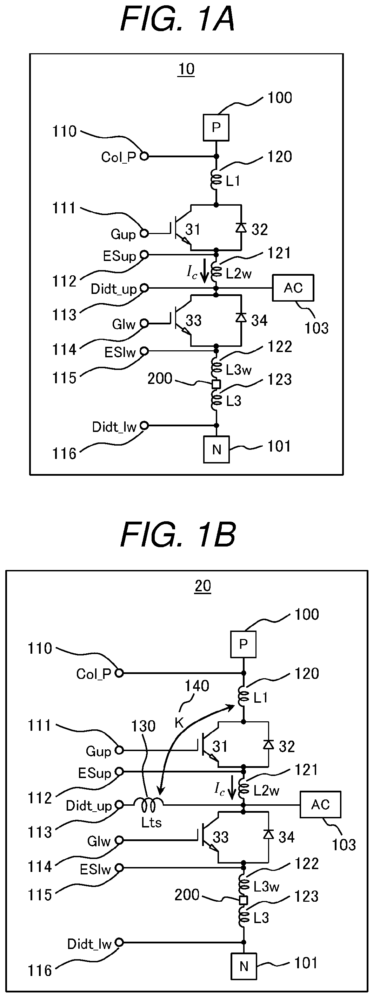

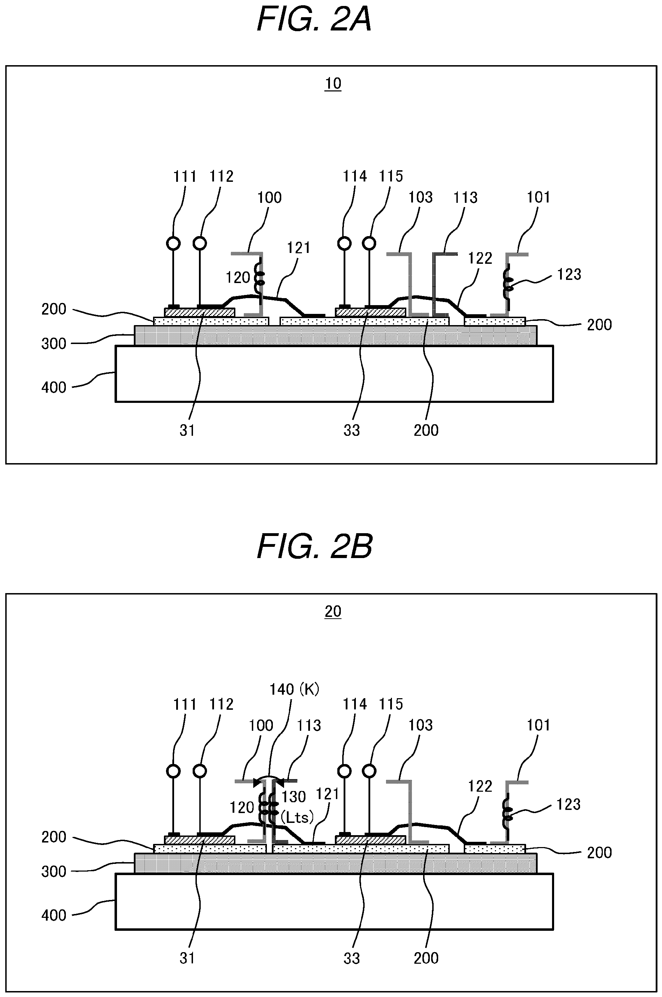

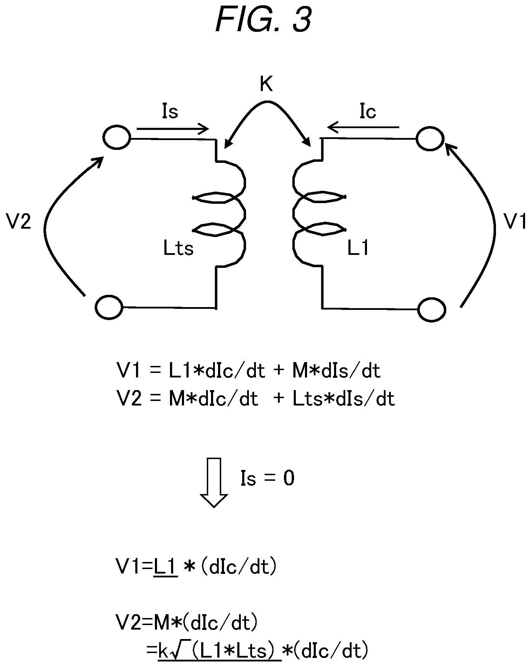

A semiconductor device according to a first embodiment of the present invention will be described with reference to FIGS. 1A to 3. FIG. 1A is an internal circuit configuration diagram of a conventional semiconductor device 10 shown as a comparative example to make the configuration of the present invention easier to understand, and FIG. 1B is an internal circuit configuration diagram of a semiconductor device 20 of the present embodiment. FIG. 2A is a cross-sectional structural diagram of a conventional semiconductor device 10 corresponding to FIG. 1A, and FIG. 2B is a cross-sectional structural diagram of the semiconductor device 20 of the present embodiment corresponding to FIG. 1B. FIG. 3 is a diagram conceptually showing the detection principle of a short-circuit current according to the present invention.

First, a basic circuit configuration common to the conventional semiconductor device 10 and the semiconductor device 20 of the present embodiment will be described using FIGS. 1A and 1B.

As shown in FIGS. 1A and 1B, the conventional semiconductor device 10 and the semiconductor device 20 of the present embodiment are semiconductor devices each having a 2in1 configuration of upper and lower arms, each of which includes, as main components, an upper arm switching element 31, a diode 32 which is an upper arm freewheel element, a lower arm switching element 33, and a diode 34 which is a lower arm freewheel element. IGBTs or MOSFETs are used for the upper arm switching element 31 and the lower arm switching element 33.

The collector side (drain side in the case of MOSFET) of the switching element 31 and diode 32 which are connected in parallel in the upper arm is connected to a positive electrode terminal 100 via a first metal wiring 120, and its inductance component is denoted by a symbol L1.

The emitter side (source side in the case of MOSFET) of the switching element 31 and diode 32 in the upper arm is connected to the collector side (drain side in the case of MOSFET) of the switching element 33 and diode 34 which are connected in parallel in the lower arm via a second metal wiring 121, and its inductance component is denoted by a symbol L2w.

The emitter side (source side in the case of MOSFET) of the switching element 33 and diode 34 in the lower arm is connected to an insulating substrate surface electrode 200 via a third metal wiring 122, and its inductance component is denoted by a symbol L3w.

Further, the insulating substrate surface electrode 200 and a negative electrode terminal 101 are connected by a fourth metal wiring 123, and its inductance component is denoted by a symbol L3.

An output terminal 103 and an upper arm overcurrent detection terminal 113 are connected independently to a connecting portion between the second metal wiring 121 and the collector side (drain side in the case of MOSFET) of the switching element 33 and diode 34 in the lower arm.

An upper arm high-side sense terminal 110 is connected between the first metal wiring 120 and the positive electrode terminal 100.

An upper arm gate control signal terminal 111 is connected to the gate of the upper arm switching element 31, and an upper arm emitter sense terminal 112 is connected to the emitter side of the upper arm switching element 31, respectively.

A lower arm gate control signal terminal 114 is connected to the gate of the lower arm switching element 33, and a lower arm emitter sense terminal 115 is connected to the emitter side of the lower arm switching element 33, respectively.

A lower arm overcurrent detection terminal 116 is connected between the fourth metal wiring 123 and the negative electrode terminal 101.

As described above, the conventional semiconductor device 10 shown in FIG. 1A and the semiconductor device 20 according to the present embodiment shown in FIG. 1B have substantially the same basic configuration, but the semiconductor device 20 according to the present embodiment is characterized in that the wiring inductance 130 (symbol Lts) is provided between the upper arm overcurrent detection terminal 113 and the connection point on the collector side of the lower arm of the second metal wiring 121, and further the wiring inductance 130 and the first metal wiring 120 are subjected to magnetic coupling 140 (coupling coefficient is indicated by a symbol K).

A basic cross-sectional structure common to the conventional semiconductor device 10 and the semiconductor device 20 according to the present embodiment will be described using FIGS. 2A and 2B.

As shown in FIGS. 2A and 2B, in the conventional semiconductor device 10 and the semiconductor device 20 according to the present embodiment, an upper arm switching element 31 and a lower arm switching element 33 are mounted on separate insulating substrate surface electrodes 200, respectively. Although not shown, a diode 32 serving as a freewheel element of an upper arm and a diode 34 serving as a freewheel element of a lower arm are also similarly mounted on separate insulating substrate surface electrodes 200, respectively.

The insulating substrate surface electrodes 200 are all arranged on the surface of a common insulating substrate 300. Further, the insulating substrate 300 has a structure in which it is bonded to a heat dissipation base plate 400.

The relationships of connections among a positive electrode terminal 100, a negative electrode terminal 101, an output terminal 103, an upper arm gate control signal terminal 111, an upper arm emitter sense terminal 112, a lower arm gate control signal terminal 114, a lower arm emitter sense terminal 115, a second metal wiring 121, a third metal wiring 122, and a fourth metal wiring 123 are as described above.

As described above, the conventional semiconductor device 10 shown in FIG. 2A and the semiconductor device 20 according to the present embodiment shown in FIG. 2B have substantially the same basic cross-sectional structure, but the semiconductor device 20 according to the present embodiment is characterized in that an upper arm overcurrent detection terminal 113 is arranged close to the positive electrode terminal 100, a wiring inductance 130 (symbol Lts) is provided between the upper arm overcurrent detection terminal 113 and the connection point on the collector side of the lower arm of the second metal wiring 121, and further the wiring inductance 130 and the first metal wiring 120 are subjected to magnetic coupling 140 (coupling coefficient is indicated by a symbol K).

Note that the "close to" of the above-described "arranged close to" means a distance at which an inductance L1 of the first metal wiring 120 and the wiring inductance 130 (inductance Lts) are mutually affected.

A main current Ic at the normal operation of the upper arm of the semiconductor device 20 (when the upper arm switching element 31 is ON and the lower arm switching element 33 is OFF) flows from the positive electrode terminal 100 and flows out from the output terminal 103 via the first metal wiring 120, the upper arm switching element 31, and the second metal wiring 121.

A main current Ic at the normal operation of the lower arm of the semiconductor device 20 (when the upper arm switching element 31 is OFF and the lower arm switching element 33 is ON) flows from the output terminal 103 and flows out from the negative electrode terminal 101 via the lower arm switching element 33, the third metal wiring 122, and the fourth metal wiring 123.

On the other hand, during an abnormal short-circuit operation of the semiconductor device 20, when the switching element of either the upper or lower arm is destroyed due to some reason, a short-circuit current Ic flows from the positive electrode terminal 100 to the negative electrode terminal 101 via all of the first metal wiring 120, the second metal wiring 121, the third metal wiring 122, and the fourth metal wiring 123 at the moment that the pair of arms turns ON.

This short-circuit current Ic causes the switching elements mounted on the semiconductor device 20 to abnormally generate heat, thereby leading to thermal runaway and destruction. Therefore, in general, the short-circuit current Ic is detected immediately after it flows, and a control circuit (not shown) turns OFF the switching element to protect it.

In the conventional semiconductor device 10 shown in FIG. 1A, in order to detect the short-circuit current Ic, the wiring inductance L2w of the second metal wiring 121 is used in the upper arm, and the sum of wiring inductances L3w+L3 of the third metal wiring 122 and the fourth metal wiring 123 is used in the lower arm.

As the principle of detecting the short-circuit current Ic, a potential difference V produced across the wiring inductance is used. However, when the potential difference V is expressed using the time rate of change di/dt in the short-circuit current Ic and a detection inductance Ls, it becomes V=Ls*di/dt.

Therefore, the larger the detection inductance Ls is for the same time rate of change di/dt, the larger the potential difference can be obtained, and the detection accuracy is improved.

However, on the other hand, when the main circuit inductance component existing in the path from the positive electrode terminal 100 to the negative electrode terminal 101 via the first metal wiring 120, the second metal wiring 121, the third metal wiring 122, and the fourth metal wiring 123 becomes large, the generated potential difference V becomes too large, so that it exceeds the breakdown voltage of the switching element, and there is a risk of a dielectric breakdown. Therefore, the smaller the main circuit inductance, the more desirable it is.

That is, there is a trade-off relationship between the detection accuracy of the short-circuit current Ic and the main circuit inductance. In the configuration of the conventional semiconductor device 10 shown in FIG. 1A, it is not possible to simultaneously realize an improvement in the detection accuracy of the short-circuit current Ic and a reduction in the main circuit inductance.

Therefore, in the semiconductor device 20 according to the present embodiment shown in FIG. 1B, as described above, the wiring inductance 130 (symbol Lts) is connected between the upper arm overcurrent detection terminal 113 which does not exist on the main circuit path, and the connection point of the second metal wiring 121 on the collector side of the lower arm, and further, the wiring inductance 130 and the first metal wiring 120 are configured to be magnetically coupled 140 (the coupling coefficient is indicated by the symbol K).

The detection voltage Vs obtained by the method of detecting the short-circuit current Ic by the conventional semiconductor device 10 shown in FIG. 1A can be expressed by the following equation (1). On the contrary, the detection voltage Vs obtained by the method of detecting the short-circuit current Ic by the semiconductor device 20 according to the present embodiment shown in FIG. 1B can be expressed by the following equation (2).

Further, the main circuit inductances Lm of the semiconductor device 10 and the semiconductor device 20 can both be expressed as in the following equation (3).

[Equation 1]

$$Vs = L_{2w} * dIc/dt \tag{1}$$

[Equation 2]

$$Vs = (L_{2w} + K\sqrt{L_1 \cdot L_{ts}}) * dIc/dt \tag{2}$$

[Equation 3]

$$L_m = L1 + L_{2w} + L_{3w} + L3 \tag{3}$$

Here, as judged from the equation (1), the only way to improve detection sensitivity by the conventional method is to increase L2w, but when L2w is increased, the main circuit inductance Lm will increase from the equation (3).

On the other hand, in the method of the present invention, according to the equation (2), it is possible to improve the detection sensitivity by increasing the wiring inductance Lts or the coupling coefficient K which does not contribute to an increase in the main circuit inductance Lm.

Note that the electromotive force at the time of a short circuit is detected by the potential difference between the upper arm emitter sense terminal 112 and the upper arm overcurrent detection terminal 113.

Therefore, according to the method of the present invention, it is possible to make the improvement in the detection sensitivity of the short-circuit current Ic and suppression of the increase in the main circuit inductance Lm compatible.

Note that there are preconditions for making the improvement in the detection sensitivity of the short-circuit current Ic and the suppression of the increase in the main circuit inductance Lm compatible. The preconditions will be described using FIG. 3. FIG. 3 is a diagram conceptually showing the principle of detecting the short-circuit current Ic according to the present invention. FIG. 3 shows an electromotive force V1 excited on the main circuit side and an electromotive force V2 excited in the inductance Lts on the detection side, when the short-circuit current Ic flows through the inductance L1 on the main circuit side.

In order to prevent the electromotive force V1 on the main circuit side from increasing while increasing the electromotive force V2 which contributes to the detection sensitivity of the short-circuit current Ic, a current Is flowing to the detection side must be zero or must be extremely smaller than the short-circuit current Ic on the main circuit side.

As shown in FIG. 3, when Is = 0, the electromotive force V1 on the main circuit side can be determined only by L1. On the other hand, the electromotive force V2 on the detection side can be increased by the coupling coefficient K and the inductance Lts on the detection side.

In general, the output impedance of the circuit configuration for detecting the electromotive force V2 on the detection side is extremely large, and the current Is on the detection side hardly flows and is zero. Therefore, it can be said that the configuration of the present invention as shown in FIG. 3 is established.

As described above, the semiconductor device 20 according to the present embodiment includes: an upper arm switching element 31 having a gate, a first main electrode (collector or drain), and a second main electrode (emitter or source) serving as a gate reference potential; a positive electrode terminal 100 serving as an external electrode, which is electrically connected to the first main electrode (collector or drain) and through which a main current Ic flows; a first auxiliary terminal (upper arm emitter sense terminal 112) serving as an external electrode, which is electrically connected to the second main electrode (emitter or source) and can detect the potential of the second main electrode (emitter or source) and through which the main current Ic does not flow; and a second auxiliary terminal (upper arm overcurrent detection terminal 113) serving as an external electrode, which is electrically connected to an AC terminal (output terminal 103) and arranged close to the positive electrode terminal 100 and through which the main current Ic subjected to magnetic coupling 140 does not flow.

Further, there is provided a first wiring pattern 200 electrically connected to a lower arm switching element 33 having a third main electrode (collector or drain) and a fourth main electrode (emitter or source) serving as a gate reference potential, and to a second main electrode (emitter or source), a third main electrode (collector or drain), and an AC terminal (output terminal 103). A second auxiliary terminal (upper arm overcurrent detection terminal 113) is connected to the first wiring pattern 200.

According to the semiconductor device 20 of the present embodiment, it is possible to realize a semiconductor device capable of improving the detection accuracy of a short-circuit current by an increase in the inductance of the main current Ic time change rate (di/dt) detection circuit without increasing the inductance of the main circuit.

Thus, the reliability of the semiconductor device and the power conversion device using the same can be improved.

Second Embodiment

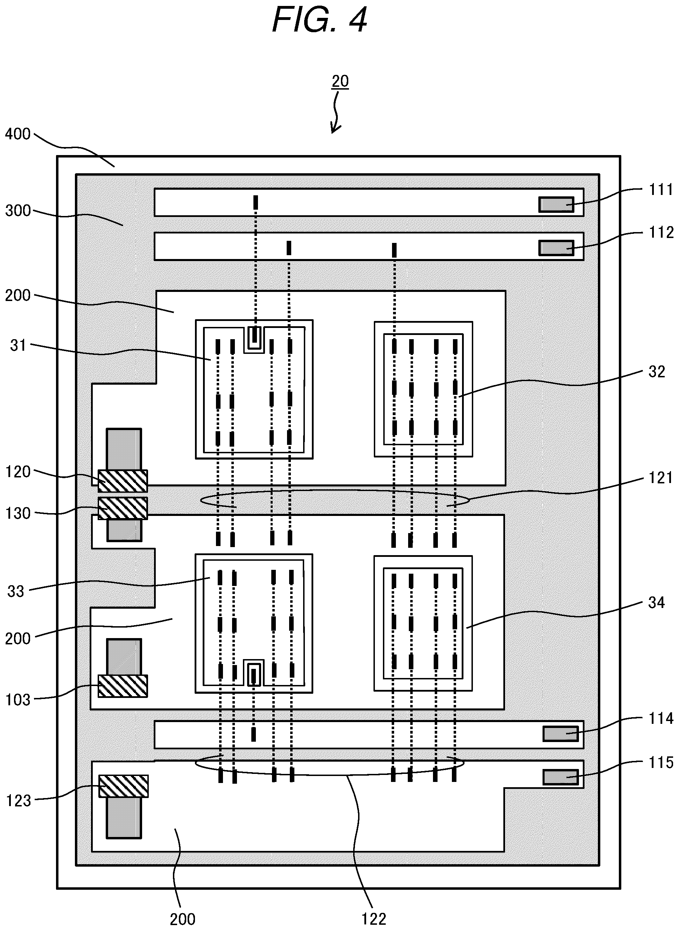

A semiconductor device according to a second embodiment of the present invention will be described with reference to FIG. 4. FIG. 4 is a top view of the semiconductor device 20 according to the present embodiment.

As shown in FIG. 4, in the semiconductor device 20 according to the present embodiment, a second metal wiring 121 which connects the emitter side electrodes of a switching element 31 and a diode 32 of an upper arm and the collector side electrodes of a switching element 33 and a diode 34 of a lower arm, is realized by a plurality of bonding wires.

Further, a laminate structure is provided in which a first metal wiring 120 connected to the positive electrode terminal 100 (not shown) and a wiring inductance 130 are arranged so as to close to each other, and flat plates are arranged to overlap each other with a gap toward the upper direction of the paper. Therefore, the wiring inductance L1 of the first metal wiring 120 and the inductance Lts of the wiring inductance 130 are magnetically coupled.

Third Embodiment

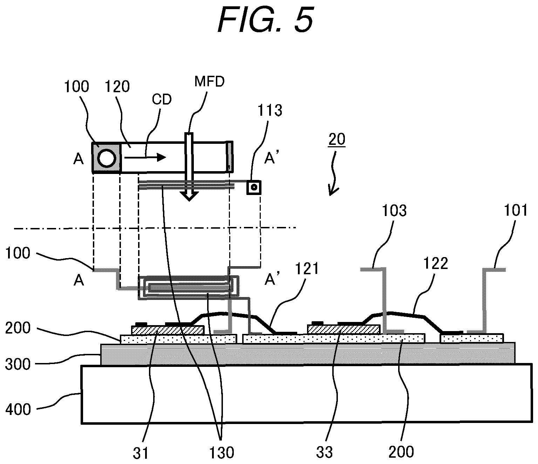

A semiconductor device according to a third embodiment of the present invention will be described with reference FIG. 5. FIG. 5 is a cross-sectional structural diagram of the semiconductor device 20 according to the present embodiment, and corresponds to a modification of the first embodiment (FIG. 2B).

The semiconductor device 20 according to the present embodiment differs from the semiconductor device 20 according to the first embodiment (FIG. 2B) in that the wiring inductance 130 is in the form of a coil.

As shown in FIG. 5, the inductance Lts of the wiring inductance 130 can be increased by making the wiring inductance 130 into the coil shape, that is, by making the wiring of the second auxiliary terminal (upper arm overcurrent detection terminal 113) into a coil shape.

Further, the coil-shaped wiring inductance 130 is arranged so as to close to a first metal wiring 120, and a planar space created by an opening of the coil is arranged orthogonally with respect to the direction of the magnetic flux MFD formed when a current flows through the first metal wiring 120 in a current direction CD.

In other words, a magnetic field generated by a current flowing through the first main electrode (collector or drain) vertically interlinks with the planar space of the opening of the coil.

Consequently, the first metal wiring 120 and the wiring inductance 130 are more closely magnetically coupled, the coupling coefficient K becomes large, and hence the detection sensitivity is improved.

Fourth Embodiment

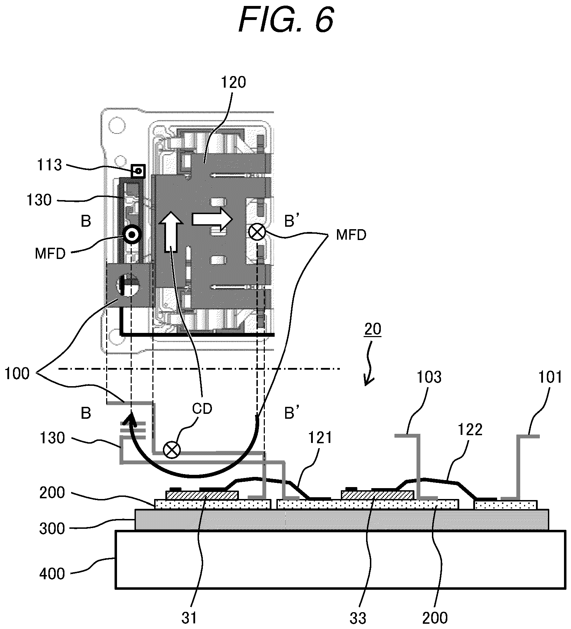

A semiconductor device according to a fourth embodiment of the present invention will be described with reference FIG. 6. FIG. 6 is a cross-sectional structural diagram of the semiconductor device 20 according to the present embodiment, and corresponds to a modification of the third embodiment (FIG. 5).

The semiconductor device 20 according to the present embodiment is different from the semiconductor device 20 according to the third embodiment (FIG. 5) in the arrangement position of the coil of the wiring inductance 130. This is because the wiring structure of the positive electrode terminal 100 and the first metal wiring 120 in the present embodiment (FIG. 6) is different from that in the third embodiment (FIG. 5).

The direction CD of the current flowing through the first metal wiring 120 shown in FIG. 5 is toward the right side of the paper in FIG. 5. On the other hand, in the present embodiment shown in FIG. 6, the current flowing from the positive electrode terminal 100 temporarily flows toward the back of the paper in FIG. 6 and then flows toward the right of the paper. When the current flows in the right direction of the paper, the current path of the first metal wiring 120 is wide and the current flows in a dispersed manner, so that the magnetic flux is also dispersed.

On the other hand, the path of the current flowing toward the back of the paper immediately after the positive electrode terminal 100 is narrow, and a magnetic flux density formed by this current becomes high. Therefore, the planar space of the coil opening of the wiring inductance 130 is arranged to be orthogonal to the direction of the magnetic flux MFD created by the current flowing toward the back of the paper.

In other words, the wiring of the positive electrode terminal 100 has a narrow portion in which the main current Ic flows in a first direction, and a wide portion in which the main current flows in a second direction perpendicular to the first direction. A magnetic field produced by the current flowing through the narrow portion vertically interlinks with the planar space of the opening of the coil.

Thus, since the wiring inductance 130 is arranged in a space where the magnetic flux is high, higher detection sensitivity can be obtained.

Fifth Embodiment

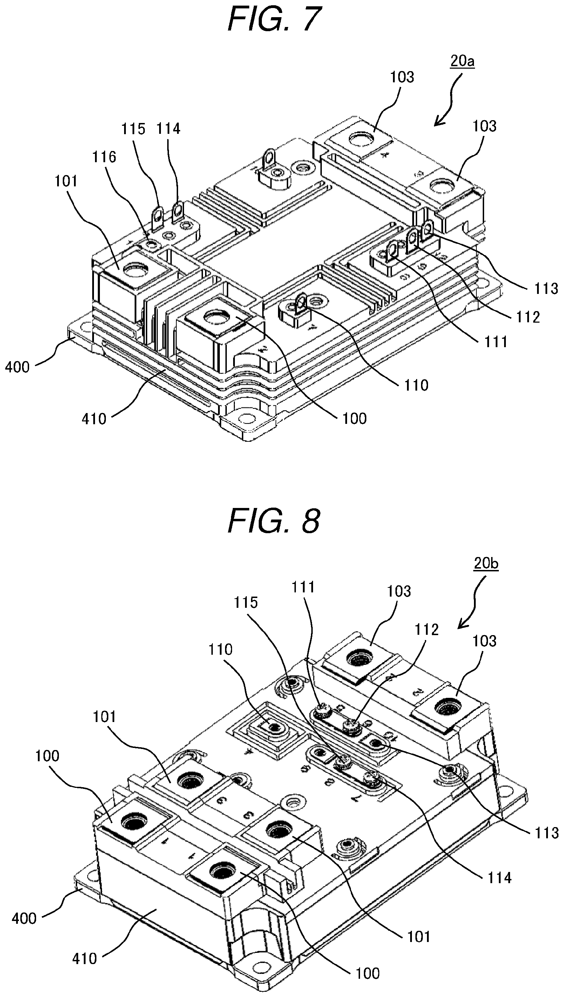

A power module according to a fifth embodiment of the present invention will be described with reference to FIG. 7. FIG. 7 is a perspective view of the power module according to the present embodiment, and shows the power module equipped with the semiconductor device of the present invention.

The power module 20a according to the present embodiment shown in FIG. 7 has a structure in which the semiconductor device 20 described in any of the first to fourth embodiments is mounted therein, and a terminal portion of the semiconductor device 20 is exposed to the outside of the power module 20a and can be contacted with the outside.

Further, the power module 20a is covered with a resin case 410, which serves to protect an internal circuit of the semiconductor device 20 while maintaining an insulating property.

Also in the power module 20a according to the present embodiment, the upper arm overcurrent detection terminal 113 and the positive electrode terminal 100 are arranged close to each other inside the resin case 410, and the first metal wiring 120 and the wiring inductance 130 are magnetically coupled.

Sixth Embodiment

A power module according to a sixth embodiment of the present invention will be described with reference to FIG. 8. FIG. 8 is a perspective view of the power module according to the present embodiment, and corresponds to a modification of the fifth embodiment (FIG. 7).

The power module 20b according to the present embodiment shown in FIG. 8 has a structure in which in a manner similar to the fifth embodiment (FIG. 7), the semiconductor device 20 described in any of the first to fourth embodiments is mounted thereinside, and a terminal portion of the semiconductor device 20 is exposed to the outside of the power module 20b and can be contacted with the outside. Similarly, the power module 20b is covered with a resin case 410, which serves to protect an internal circuit of the semiconductor device 20 while maintaining an insulating property.

As in the power module 20b according to the present embodiment, the upper arm overcurrent detection terminal 113 and the positive electrode terminal 100 are arranged close to each other inside the resin case 410, and the first metal wiring 120 and the wiring inductance 130 are magnetically coupled.

The power module 20b according to the present embodiment is different from the power module 20a according to the fifth embodiment (FIG. 7) in that the two positive electrode terminals 100 and the two negative electrode terminals 101 are provided in the present embodiment.

With this configuration, it is possible to make a larger current to flow.

The present invention is not limited to the above-described embodiments, and further includes various modifications. For example, the above-described embodiments have been described in detail in order to facilitate the understanding of the present invention, and the present invention is not necessarily limited to those including all of the described configurations. In addition, part of the configuration of one embodiment can be replaced with the configurations of other embodiments, and in addition, the configuration of the one embodiment can also be added with the configurations of other embodiments. In addition, part of the configuration of each of the embodiments can be subjected to addition, deletion, and replacement with respect to other configurations.

List of Reference Signs

10, 20 ... semiconductor device, 20a, 20b ... power module, 31 ... upper arm switching element, 32 ... upper arm freewheel element (diode), 33 ... lower arm switching element, 34 ... lower arm freewheel element (diode), 100 ... positive electrode terminal, 101 ... negative electrode terminal, 103 ... output terminal, 110 ... upper arm high-side sense terminal, 111 ... upper arm gate control signal terminal, 112 ... upper arm emitter sense terminal, 113 ... upper arm overcurrent detection terminal, 114 ... lower arm gate control signal terminal, 115 ... lower arm emitter sense terminal, 116 ... lower arm overcurrent detection terminal, 120 ... first metal wiring, 121 ... second metal wiring, 122 ... third metal wiring, 123 ... fourth metal wiring, 130 ... wiring inductance, 140 ... magnetic coupling between wiring inductance 130 and first metal wiring 120, 200 ... insulating substrate surface electrode, 300 ... insulating substrate, 400 ... heat dissipation base plate, 410 ... resin case, CD ... current direction, MFD ... magnetic flux direction.

**Claims**

1. A semiconductor device comprising:

   an upper arm switching element having a gate, a first main electrode, and a second main electrode serving as a gate reference potential;
   a positive electrode terminal serving as an external electrode electrically connected to the first main electrode and through which a main current flows;
   a first auxiliary terminal serving as an external electrode which is electrically connected to the second main electrode and capable of detecting a potential of the second main electrode, and through which the main current is made to be prevented from flowing; and
   a second auxiliary terminal serving as an external electrode which is electrically connected to an AC terminal and arranged close to the positive electrode terminal and through which a main current subjected to magnetic coupling is made to be prevented from flowing.

2. The semiconductor device according to claim 1, including:

   a lower arm switching element having a third main electrode and a fourth main electrode which serves as a gate reference potential; and
   a first wiring pattern electrically connected to the second main electrode, the third main electrode, and the AC terminal, wherein
the second auxiliary terminal is connected to the first wiring pattern.

3. The semiconductor device according to claim 1, wherein
the wiring of the second auxiliary terminal is in the form of a coil.

4. The semiconductor device according to claim 3, wherein
a magnetic field generated by a current flowing through the first main electrode vertically interlinks with a planar space of an opening of the coil.

5. The semiconductor device according to claim 3, wherein

the wiring of the positive electrode terminal includes a narrow portion through which a main current flows in a first direction, and a wide portion through which the main current flows in a second direction perpendicular to the first direction, and
a magnetic field generated by a current flowing through the narrow portion vertically interlinks with the planar space of the opening of the coil.

6. The semiconductor device according to claim 2, wherein
the second main electrode and the third main electrode are connected via a bonding wire.

7. The semiconductor device according to claim 1, wherein
the wiring of the positive electrode terminal and the wiring of the second auxiliary terminal are arranged in a laminate structure in which flat plates are arranged so as to overlap with each other with a gap.

8. The semiconductor device according to claim 1, which is covered with a resin case, wherein
the positive electrode terminal, the first auxiliary terminal, and the second auxiliary terminal are exposed to the outside of the resin case.

9. The semiconductor device according to claim 8, which includes two sets of the positive electrode terminals and negative electrode terminals each paired with the positive electrode terminal, wherein
the two sets of positive electrode terminals and negative electrode terminals are both exposed to the outside of the resin case.

10. A power conversion device using the semiconductor device according to any one of claims 1 to 9.

## FIG. 1A

## FIG. 1B

## FIG. 2A

## FIG. 2B

# FIG. 3

V1 = L1*dIc/dt + M*dIs/dt

V2 = M*dIc/dt  + Lts*dIs/dt

Is = 0

V1=L1 * (dIc/dt)

V2=M*(dIc/dt)

=k√(L1*Lts) *(dIc/dt)

# FIG. 4

# FIG. 5

# FIG. 6

# FIG. 7

# FIG. 8

## INTERNATIONAL SEARCH REPORT

| | International application No. |
|---|---|
| | **PCT/JP2022/042988** |

**A. CLASSIFICATION OF SUBJECT MATTER**

*H02M 7/48*(2007.01)i; *H01L 25/07*(2006.01)i; *H01L 25/18*(2023.01)i; *H02M 1/08*(2006.01)i
FI: H02M7/48 Z; H02M1/08 Z; H01L25/04 C

According to International Patent Classification (IPC) or to both national classification and IPC

**B. FIELDS SEARCHED**

Minimum documentation searched (classification system followed by classification symbols)

H02M7/00-7/98; H02M1/00-3/44; H01L25/07; H01L25/18

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2014-120563 A (MITSUBISHI ELECTRIC CORP.) 30 June 2014 (2014-06-30) paragraphs [0001]-[0081], fig. 1-15 | 1-2, 6, 8-10 |
| A | | 3-5, 7 |
| Y | JP 2016-066974 A (HITACHI, LTD.) 28 April 2016 (2016-04-28) paragraphs [0001]-[0097], fig. 1-12 | 1-2, 6, 8-10 |
| A | | 3-5, 7 |

| ☐ Further documents are listed in the continuation of Box C. | ☑ See patent family annex. |
|---|---|

\*    Special categories of cited documents:
"A"    document defining the general state of the art which is not considered to be of particular relevance
"E"    earlier application or patent but published on or after the international filing date
"L"    document which may throw doubts on priority claim(s) or which is cited to establish the publication date of another citation or other special reason (as specified)
"O"    document referring to an oral disclosure, use, exhibition or other means
"P"    document published prior to the international filing date but later than the priority date claimed

"T"    later document published after the international filing date or priority date and not in conflict with the application but cited to understand the principle or theory underlying the invention
"X"    document of particular relevance; the claimed invention cannot be considered novel or cannot be considered to involve an inventive step when the document is taken alone
"Y"    document of particular relevance; the claimed invention cannot be considered to involve an inventive step when the document is combined with one or more other such documents, such combination being obvious to a person skilled in the art
"&"    document member of the same patent family

| Date of the actual completion of the international search | Date of mailing of the international search report |
|---|---|
| **27 December 2022** | **10 January 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2022/042988**

| Patent document cited in search report | | | Publication date (day/month/year) | Patent family member(s) | | | Publication date (day/month/year) |
|---|---|---|---|---|---|---|---|
| JP | 2014-120563 | A | 30 June 2014 | (Family: none) | | | |
| JP | 2016-066974 | A | 28 April 2016 | WO | 2016/047455 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007259533 A

- JP 2017092789 A